# EUROPEAN PATENT SPECIFICATION

(11) **EP 1 973 179 B1**
(45) Date of publication and mention of the grant of the patent: **25.08.2010**
(21) Application number: 07104436.6
(22) Date of filing: 19.03.2007
(51) Int. Cl.: H01L 51/05

(54) **Guiding nanowire growth**
Gerichtetes Wachstum von Nanodrähten
Guidage de croissance de nanofils

(43) Date of publication of application: 24.09.2008
(73) Proprietor: Hitachi Ltd., Tokyo (JP)
(72) Inventor: Blackburn, Arthur Malcolm, Cambridge, Cambridgeshire CB1 3HN (GB)
(74) Representative: Piotrowicz, Pawel Jan Andrzej

(56) References cited:
- FR-A1- 2 829 873
- US-A1- 2005 188 444
- US-A1- 2005 230 356
- US-A1- 2006 060 863

## Description

The present invention relates to a method of guiding wire growth, to a device for guiding wire growth and to a device including grown wires particularly, but not exclusively nanowires, such as carbon nanotubes or semiconductor nanorods.

Elongate members having a diameter of the order of 1 to 100 nanometres (herein referred to "nanowires") formed of carbon, silicon and other conducting materials can exhibit unusual electrical and/or optical properties which may be exploited in electronic and optical devices. For example, semiconductor nanowires often exhibit higher mobility compared with bulk material and can be used in fast-switching logic devices. Carbon nanotubes (i.e. a form of nanowire) can carry currents at high current density (>10⁹ Acm⁻²) and can be used as integrated circuit interconnects.

Many types of nanowires can be grown or deposited. This can help simplify device fabrication since the critical dimension, namely the diameter of the nanowire, can be defined without using lithography and etching.

Notwithstanding these advantages, nanowires are not yet widely used since they can be difficult to grow and incorporate into conventional devices, such as transistors, in a reliable and controlled manner.

Several attempts have been made to study and/or address this problem.

"Uniform patterned growth of carbon nanotubes without surface carbon" by K. B. K. Teo et al., Applied Physic Letters, volume 79, p. 1534 (2001) describes plasma-enhanced chemical-vapor deposition (PECVD) of carbon nanotubes. The position at which nanotubes are deposited can be controlled using a patterned catalyst. However, the orientation of the nanotubes cannot be freely varied since this is limited by the direction of the plasma electric field and depends on sputtering processes. This technique is ideally suited to growing nanotubes orientated perpendicularly to the surface of the substrate. However, this is not suited to planar devices, in which transport occurs parallel to the surface of the substrate.

Similarly, "Effects of catalyst film thickness on plasma-enhanced carbon nanotube growth", S. Hofman et al., Journal Applied Physics, volume 98, p. 034308 (2005) and "Catalytic Chemical Vapor Deposition of Single-Wall Carbon Nanotubes at Low Temperatures" by M. Cantoro et al., Nano Letters, volume 6, p. 1107 (2006) describe depositing carbon nanostructures using PECVD using acetylene. As in similar studies, the positions in which nanotubes grow can be controlled. Nanotubes orientation can be varied to some degree according to the density of particles of catalyst used for nucleating growth. In particular, if the nucleation density is high, then nanotubes grow perpendicularly to the surface of the substrate. However, if nucleation density is low, then nanotubes grow generally along the surface of the substrate although in randomly orientated directions.

Three terminal electronic devices have been fabricated using nanotubes grown by chemical vapour deposition, for example as described in "High-Current Nanotube Transistors" by R. Seidel et al., Nano Letters, volume 4, p. 831 (2004).

"Novel Nanotube-on-Insulator (NOI) Approach toward Single-Walled Carbon Nanotube Devices" by X. Liu, S. Han and C. Zhou, Nano Letters, volume 6, p 34 (2006) describes growing aligned nanotube arrays on crystalline sapphire substrates. Using this technique, nanowires can be linearly constrained and aligned with specific crystal directions. However, this has a drawback that the orientation of the nanowires is limited to certain directions. Furthermore, the process only works under a narrow range of process conditions for a specific type of nanowire. Therefore, this technique has limited applicability.

US-A-2006/0060863 describes systems and methods for controllably growing nanostructures, such as nanotubes, on a substrate, thus enabling the length and/or orientation of the nanostructures to be selectively controlled. A substrate's surface is selectively patterned to include topological structures for influencing the nanostructure growth along the surface from a catalyst.

In the prior art structures and devices hereinbefore described, carbon nanotubes are left where they are grown. However, nanotubes can be grown on one substrate and transferred to another substrate, where they are manipulated into position. For instance, "Controlled Placement of Individual Carbon Nanotubes" by X. M. H. Huang et al., Nano Letters, volume 5, pp. 1515 - 1518 (2005) describes a method of fabrication using this technique (often referred to as "direct mechanical transfer"). Although direct mechanical transfer offers good control over the position and orientation of nanotubes, it is not suited to high volume manufacturing since each nanowire is individually manipulated.

Liquid-based methods of positioning nanowires are known whereby nanowires are aligned while suspended in solvent by applying pressure to the surface of the solvent and then set down on a substrate when the solvent is removed. For example, "Scalable Interconnection and Integration of Nanowire Devices without Registration" by S. Jin et al., Nano Letters, volume 4, pp. 915 - 919 (2004) describes organising nanowires using Langmuir-Blodgett films.

"Orientation of Carbon Nanotubes Using Electrophoresis" by K. Yamamoto, S. Akita and Y. Nakayama, Japanese Journal of Applied Physics, volume 35, p. L917 (1996) describes orientating carbon nanotubes in isopropyl alcohol using electric fields. Likewise, "DC electric field assisted alignment of carbon nanotubes on metal electrodes" by M. S. Kumara et al., Solid-State Electronics, volume 47, p. 2075 (2003) describes aligning carbon nanotubes suspended in a liquid across metal electrodes.

Although liquid-based methods of positioning nanowires offer advantages in that they allow large numbers of nanowires to be manipulated simultaneously, they still suffer drawbacks, notably bundling and agglomeration.

The present invention seeks to provide an improved method of fabricating a nanowire device.

According to a first aspect of the present invention there is provided a method of guiding nanowire growth, the method including providing a barrier on a surface of a substrate such that the barrier is arranged to impede nanowires growing across the surface, providing a passage through the barrier, the passage being parallel to the substrate surface, providing a region of catalyst for nucleating growth of nanowires on the surface of the substrate and adjacent to the barrier wherein the barrier has an overhanging profile.

The method may comprise arranging the region to be wider than an opening to the passage. The method may comprise arranging the region to extend across the front of the opening.

The method may comprise arranging the barrier and catalyst region on an upper surface of a substrate such that barrier is arranged to impede nanowires growing along the upper surface. Thus, the method can allow nanowires to be grown in-situ and to be incorporated into conventional circuits (e.g. those fabricated using conventional planar processing techniques) without the need for directly transferring or positioning.

Providing the region of catalyst may comprise providing a region of cobalt, iron, nickel, gold, platinum and/or copper.

The method may further include growing the nanowires, whereby at least one nanowire stems from the catalyst region into the passage.

Growing the nanowires may comprise growing nanowires by chemical vapour deposition. Growing the nanowires may comprise growing carbon nanotubes.

The method may further comprise providing another barrier and providing passage through the other barrier. The method may comprise arranging the other barrier between the catalyst region and the barrier and aligning the passage through the other barrier with the passage through the barrier.

The method may further comprise providing conductive regions in the barrier on at least one side of the passage for applying an electric field within the passage. Thus, a self-aligned gate can be provided for the nanowire.

The method may comprise arranging the passage to have a width less than or equal to 1 µm. The method may further comprise arranging for an edge of the catalyst region to be less than or equal to 5 µm from an opening of the passage.

According to a second aspect of the present invention there is provided a device comprising a substrate, a barrier on a surface of the substrate wherein the barrier is arranged to impede nanowires growing across the surface, a passage through the barrier, the passage being parallel to the substrate surface and a region of catalyst for nucleating growth of nanowires on the surface of the substrate and adjacent to the barrier, wherein the barrier has an overhanging profile. The region may be wider than an opening of the passage. The barrier and catalyst region may be disposed on an upper surface of a substrate such that the barrier is arranged to impede nanowires growing along the upper surface. The region of catalyst may comprise cobalt, iron, nickel, gold, platinum and/or copper.
The device may further comprise nanowires, wherein at least one nanowire stems from the catalyst region into the passage. One or more than one nanowire may stem from the catalyst region into the passage. The nanowires may comprise carbon nanotubes or semiconductor nanorods.

The passage may comprise another barrier and a passage through the other barrier. The other barrier between the catalyst region and the barrier and the passage through the other barrier may be aligned with the passage through the barrier. The barrier or the other may include a conductive region on at least one side of the passage, for example either side of the passage, for applying an electric field within the passage. The passage may have a width less than or equal to 1 µm and an edge of the catalyst region may be arranged to be less than or equal to 5 µm from the opening.

Embodiments of the present invention will now be described, by way of example, with reference to the accompanying drawings in which:
Figure 1 is a perspective view of a first embodiment of a nanowire device according to the present invention;
Figure 2 is a plan view of the device shown in Figure 1;
Figure 3 is a cross sectional view of the device shown in Figure 2 taken along the line A - A' or B - B';
Figure 4 illustrates a circuit including the nanowire device shown in Figure 1;
Figure 5 is a scanning electron micrograph of a nanowire passing through an opening in a wall and another nanowire whose propagation is stopped by the wall;
Figure 6 is a process flow diagram illustrating a method of fabricating the device shown in Figure 1;
Figures 7a to 7d illustrate the device at different stages during early stages of fabrication;
Figures 8a to 8d illustrate the device shown in Figure 1 at different stages during late stages of fabrication;
Figure 9 is a second embodiment of a nanowire device according to the present invention;
Figure 10 illustrates etching the device to provide a space around a nanowire;
Figure 11 shows an electron source and a cathode holder; and
Figure 12 illustrates a circuit including the nanowire device shown in Figure 9.

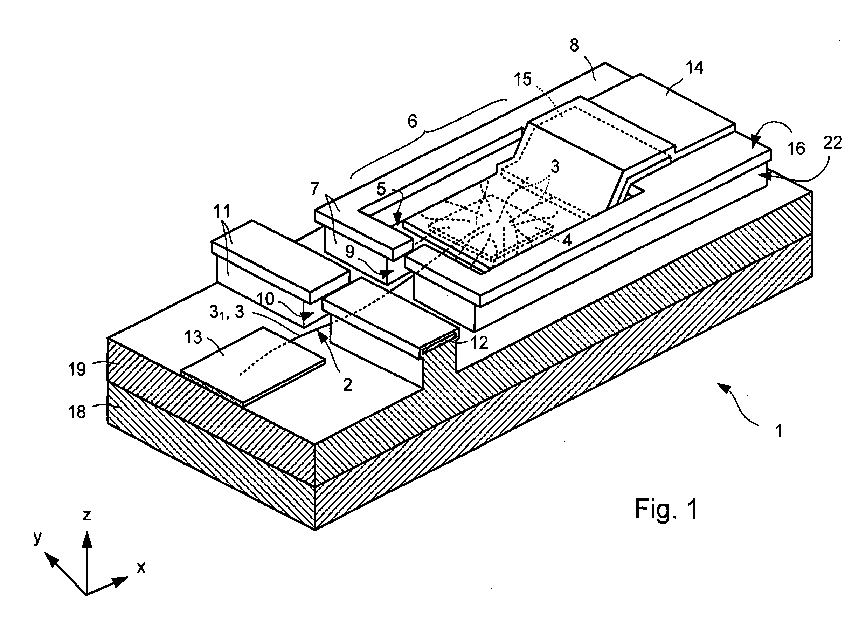

Referring to Figures 1 to 3, a nanowire device 1 in accordance with the present invention is shown. The nanowire device 1 is a field effect transistor (FET) having a channel 2 provided by a nanowire 3₁. The nanowire 3₁ is one of a plurality of nanowires 3 stemming from a catalyst pad 4 disposed on a base 5 (or "floor") of a region 6 defined, at least in part, by a wall portion 7 of a mesa 8 which provides a barrier for impeding nanowires during growth except through a passage 9 (herein also referred to as an "exit"). The nanowire 3₁ extends through another passage 10 in another wall 11 which provides first and second sides of a split gate 12. Thus, the channel 2 and gate 12 are self-aligned.

The nanowire 3₁ is contacted at each end by source and drain contacts 13, 14. Optionally, a dielectric pad 15 is provided which overlaps an edge of the mesa 8 to provide a bridge which allows the drain contact 14 to run from the floor 5 of the region 6 onto an upper surface 16 of the mesa 8.

Herein, the term "nanowire" is used to refer to an elongate member having a diameter of the order of 1 to 100 nanometres and is intended to include nanotubes, such as single- and multiple-walled carbon nanotubes, and nanorods, e.g. formed of silicon or other semiconductor material. The term is intended to cover structures formed not only from conducting material, but also non-conducting material. Nanowire may be functionalised.

In this embodiment, the nanowires 3 are single-walled carbon nanotubes (SWNT). Additionally or alternatively, multiple-walled carbon nanotubes may be used. In some embodiments, semiconductor nanorods, for example formed of silicon, may be used. In some embodiments, larger wires may be used, for example wires having a diameter of the order of 1 or 10 micrometres.

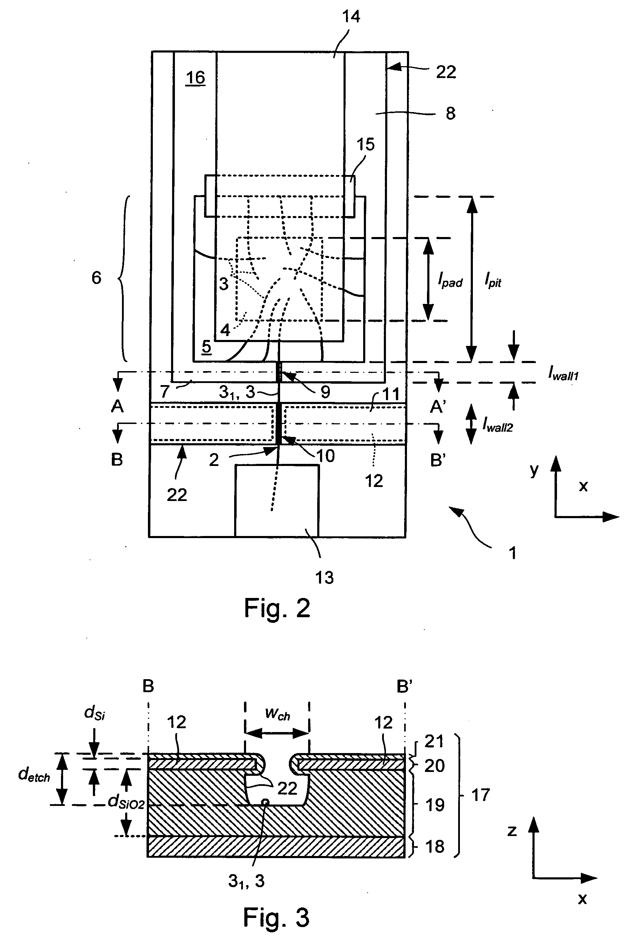

Referring in particular to Figure 3, the nanowires 3 are formed on a patterned silicon-on-insulator substrate 17 having a silicon base layer 18, a patterned silicon dioxide layer 19, a patterned crystalline silicon layer 20 and a capping silicon dioxide layer 21.

The silicon layer 20 is doped with phosphorus (P) with an areal doping concentration of 5×10¹⁴ cm⁻², equivalent to bulk doping concentration of 6.4×10¹⁹ cm⁻³. Other n-type impurities, such as arsenic (As), may be used. Alternatively, the silicon layer 20 may be doped with a p-type impurity, such as boron (B). The silicon layer 20 may doped to a higher or lower concentration, for example, to a (bulk) concentration of the order of 10¹⁸, 10¹⁹ or 10²⁰ cm⁻³. The silicon layer 20 is single crystal. However, the silicon layer 20 may be polycrystalline.

As shown in Figure 3, the silicon dioxide layer 19 has a thickness, *d_{SiO2},* between 30 and 400 nm. In this example, the thickness *d_{SiO2}* is 100 nm. The silicon layer 20 may have a thickness, *d_{Si},* between 20 and 100 nm. In this example, the thickness *d_{Si}* is 40 nm. The silicon dioxide capping later 21 has a thickness, *d_{cap},* of about 10 to 15 nm. The mesa 8 has a height *d_{etch}* = *(d_{Si}* + *d_{cap}* + Δ), where Δ ≈ 30 nm, i.e. the mesa 8 is defined by etching into the silicon dioxide layer 19 by about 30 nm. The mesa 8 may have a different height. For example, the etch may penetrate into the silicon dioxide layer 19 by between 5 and 50 nm, i.e. 5 nm < Δ < 50 nm. The penetration depth Δ is chosen so as to isolate the source 13 from the gate 12 (and the device 1 from other devices, if present) and to maximise the electric field provided by the gate 12 at the nanowire 3.

As shown in Figure 2, the enclosure 5 is generally square having sides *lₚᵢₜ, wₚᵢₜ* = 18 µm. The catalyst pad 4 is generally square having sides *l_{pad}, w_{pad} =* 10 µm. The enclosure 5 may be larger or smaller, for example 1 µm ≤ *lₚᵢₜ, wₚᵢₜ ≤* 100 µm. Likewise, the catalyst pad 4 may be larger or smaller according to the size of the pit 5, i.e. *l_{pad}, w_{pad} < lₚᵢₜ, wₚᵢₜ.* The pad 4 and/or the pit 5 need not be square, but can be (regularly or irregularly) polygonal, circular or elliptical.

As shown in Figure 3, the openings 9, 10 have a width *w_{cb}* = 100 nm. However, the openings 9, 10 can have a width between 40 and 1000 nm, i.e. 40 nm ≤ *w_{cb}* ≤ 1000 nm. The openings 9, 10 may have a width less than 40 nm, i.e. *w_{cb}* < 40 nm. The width of the openings 9, 10 can be chosen according to the diameter and density of nanowires 3 and on how many nanowires 3 should pass through the opening 9, 10.

Also as shown in Figure 2, the wall 7 and other wall 11 have lengths *l_{wall1}*, *l_{wall2}* of 1 and 2 µm respectively. The walls 7, 11 can have lengths of the order of 1 µm. In some embodiments the walls 7, 11 have length of the order of 10 or 100 nm.

Etched edges 22 of the mesa 8 have an overhanging profile along a vertical direction, when viewed in cross section. As will be explained in more detail later, the overhanging profile may be achieved by using a wet and/or dry etch which provides an undercut etch profile and/or by swelling resulting from thermal oxidation of the silicon layer 20.

An overhanging profile may also be achieved by depositing a silicon dioxide layer using chemical vapour deposition (CVD) over an trench having non-overhanging (e.g. vertical) sidewall profile. Reference is made to "Planarization of Phosphorus-Doped Silicon Dioxide" by A. C. Adams and C. D. Capio, Journal of the Electrochemical Society: Solid-State Science and Technology volume 128, pp. 423 - 429 (1981) and Figure 13A therein which shows a silicon dioxide layer having surface angle greater than 90°. Those skilled in the art will appreciate that a silicon dioxide layer having step coverage with a similar profile and which is not doped with silicon can be obtained by routine experiment, e.g. by varying deposition pressure, temperature and feed gas flow rates.

Referring in particular to Figure 1, even though the edges 22 have an overhanging profile, the drain contact 13 or dielectric pad 15 can bridge the gap formed by the overhanging profile, for example by following the contour profile as a result of conformal deposition, by forming a so-called "air bridge" or by filling the gap by virtue of planarization.

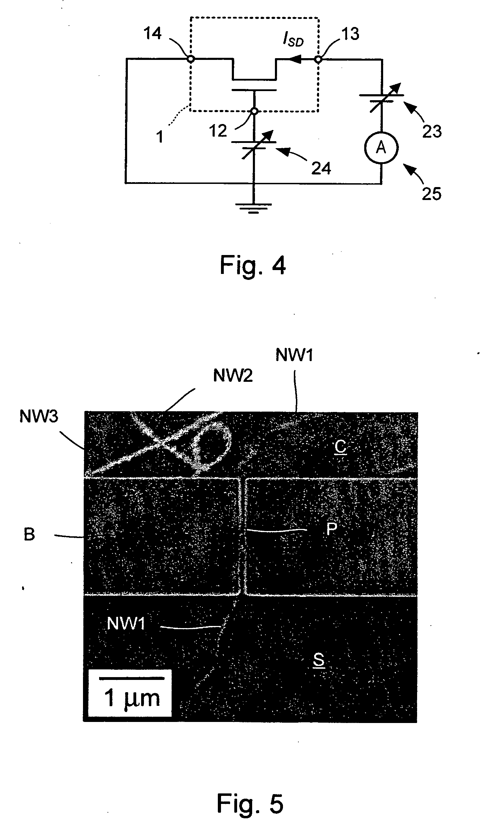

Referring to Figure 4, first and second voltage sources 23, 24 are used to apply biases between the source 13 and drain 14 and between the source 13 and gate 12 respectively. A current meter 25 is used to measure source-drain current, *I_{SD}.*

Referring again to Figure 2, in this embodiment, the mesa 8 is arranged to surround the catalyst pad 4 so as to form a pit or enclosure. Thus, the wall portion 7 prevents propagation of nanowires 3 during growth along the upper surface 5 of the substrate 17. However, the mesa 8 need not surround the catalyst pad 4. For example, the catalyst pad 4 may have one or more "open" sides. Thus, nanowires 3 are free to propagate in these directions as far as they can, with the longest nanowires 3 extending up to a maximum expected range, as determined by growth conditions. It will be appreciated that if no other critical part of the device 1 or part of other device is located within the maximum range such that a stray nanowire 3 does not form an unwanted short or produce some other deleterious effect, such as causing contamination, then unbounded growth of stray nanowires 3 may be tolerated. The mesa 8 may be arranged to form a trench open at one or both ends.

Figure 5 is a scanning electron micrograph illustrating carbon nanotubes grown using a method in accordance with the present invention. The image is obtained using a scanning electron microscope using an electron beam having a beam energy of 1 keV. The carbon nanotubes stem from a catalyst pad C on an etched silicon substrate S providing a wall B having a passage P substantially the same as those described earlier. Surface-bound carbon nanotubes NW1, NW2, NW3 are grown under substantially the same conditions described hereinafter. As shown in Figure 5, the passage P guides or constrains nanowires during growth. Thus, one of the nanowires NW1 is guided through the wall by passage P, whereas other nanowires NW2, NW3 are impeded by the wall.

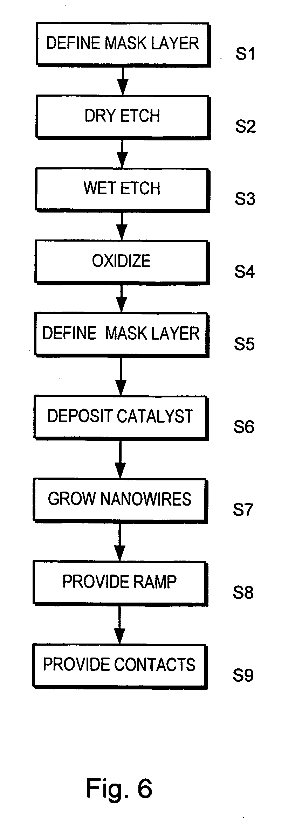

Referring to Figures 6, 7a to 7d and 8a to 8c, an embodiment of a method of fabricating the nanowire device 1 shown in Figure 1 will now be described.

In the following description, fabrication of only one nanowire device 1 will be described and illustrated. However, it will be appreciated by those skilled in the art that more than one nanowire device 1 can be fabricated simultaneously on a silicon-on-insulator substrate which may be in the form of a wafer or part of the wafer (often referred to as a "chip" or "die"). It will also be appreciated that nanowire devices 1 may be connected and arranged into circuits (not shown) and that other devices, such as conventional field effect transistors, other elements, such as conducting tracks and bond pads, and other features and fabrication aids, such as registration marks, may be defined. However, fabrication of these other devices, elements and features are not described here for the sake of clarity and brevity.

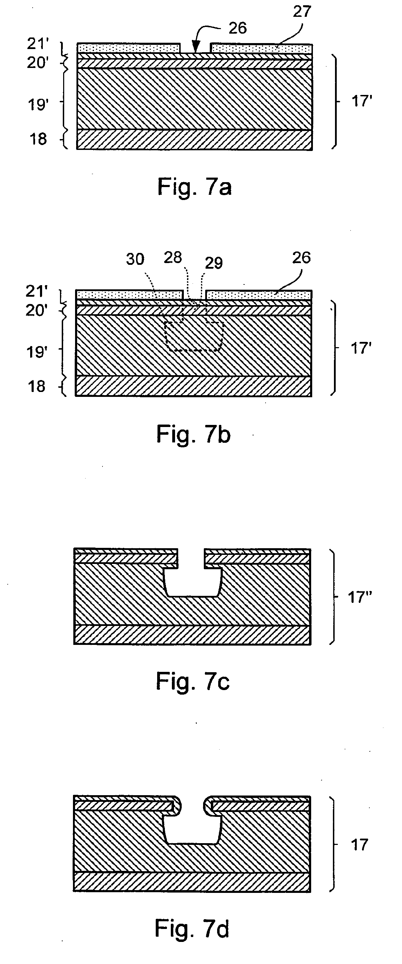

Referring in particular to Figure 7a, a layer of polymer resist, such as photoresist or polymethylmethacrylate (PMMA), or a removable metal, such as a layer of aluminium, is applied to an upper surface 26 of un-patterned silicon-on-insulator substrate 17' (only a portion of which is shown in Figure 7a for clarity) and patterned to provide a mask layer 27 (step S1).

Referring also to Figure 1, the mask layer 27 is used to define the mesa 8 including wall 9 bounding the enclosure 6 and having therein an opening 9. The mask layer 27 is also used to define the other wall 11 having an opening 10.

The substrate 17' includes a silicon base layer 18, a silicon dioxide layer 19', a silicon layer 20' and a capping silicon dioxide layer 21'. The substrate 17' is made using a separation by implantation of oxygen (SIMOX) process. However, the substrate 17' can be made in other ways, for example, by wafer bonding.

A polymer resist layer is patterned by selectively exposing, for example by using a reticle to mask a blanket of light across the layer or by scanning an electron beam over the layer, and developing the resist to remove the exposed regions of the polymer resist layer.

A metal layer may be patterned either by applying and patterning a polymer resist layer before the metal layer is deposited and removing metal which overlies patterned resist (so called "lift-off") or by applying and patterning a polymer resist layer after the metal layer is deposited and etching exposed regions of the layer.

Referring in particular to Figure 7b, portions 28, 29 of capping silicon dioxide layer 21' and silicon layer 20' are removed by dry etching (step S2). Reactive ion etching using silicon tetrachloride (SiCl₄), carbon tetrafluoride (CF₄) and oxygen (O₂) as feed gases is used. Other dry etches, such ion beam etching, can be used. A highly anisotropic dry etch is preferred to help define fine features. Wet etches, such as potassium hydroxide (KOH) based etches, may be used.

Referring still to Figure 7b, portions 30 of the silicon dioxide layer 19' are removed by wet etching (step S3). Wet etching employing a hydrofluoric (HF) acid based etch is used. An isotropic wet etch is preferred to help define an overhanging profile. Nevertheless an anisotropic dry etches may be used. Even if no overhanging profile is created in this step, an overhanging profile may be achieved by a subsequent oxidation step or by depositing silicon dioxide as described earlier.

The mask layer 27 is removed. Polymer resists are removed by a solvent, such as acetone. A metal resist may be chemically etched. The etched substrate 17" with the mask layer removed is shown in Figure 6c. The etched substrate 17" is cleaned using conventional RCA cleaning techniques.

Referring now to Figure 7d, the etched substrate 17" (Figure 7c) is thermally oxidized to provide an oxidized, etched substrate 17 (step S4). For a silicon layer having a thickness of 40 nm, to produce a silicon dioxide layer having a thickness of 20 nm, the etched substrate 17" (Figure 7c) is oxidized at 1000 °C for 13 minutes in dry oxygen gas having a flow rate of 0.2 litres per minute.

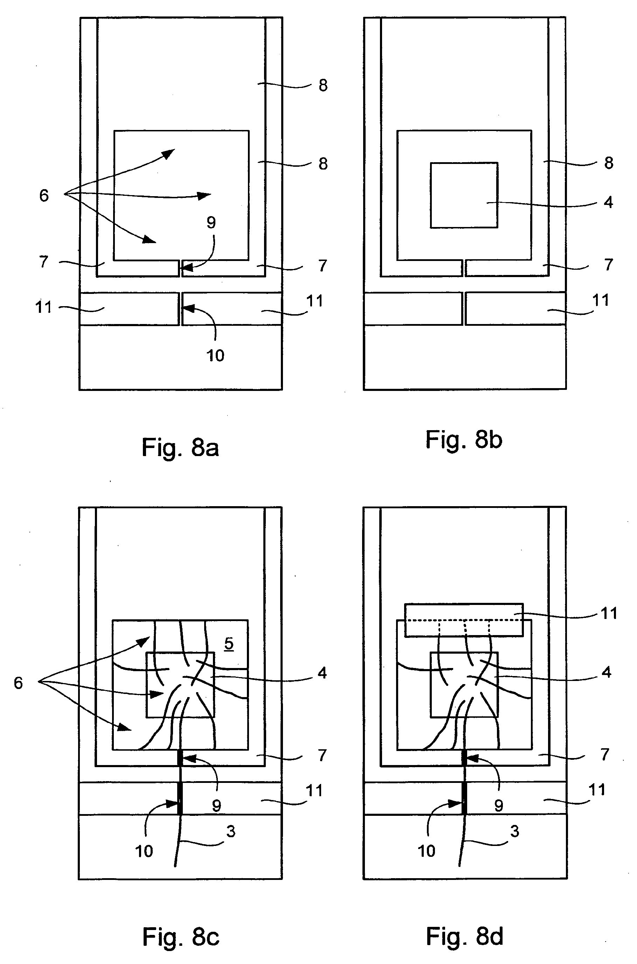

Referring to Figure 8a, the oxidized, etched substrate 17 (hereinafter referred to simply as the "substrate" is shown in plan view. The fabrication steps hereinbefore described define the mesa 8 including wall 7 bounding the enclosure 6 and having therein an opening 9 and also the wall 11 having an opening 10 and providing split gate 12 (Figure 2). This provides a template for controlling the direction in which nanowires extend during growth.

A layer of polymer resist (not shown) is applied over patterned surface 30 of the substrate and patterned to provide a mask layer (not shown) (step S5). The mask layer is used to define the catalyst region 4 (Figure 1).

A layer of catalyst is deposited (step S6) and portions of the layer overlying resist are lifted-off in acetone. The corresponding structure, including a pad of catalyst 4, is shown in Figure 8b.

A suitable catalyst for a given nanowire material can be found by routine experiment. Suitable catalysts for growing carbon nanotubes include cobalt (Co), iron (Fe), nickel (Ni), gold (Au), platinum (Pt) or copper (Cu), or an alloy of two or more metals.

The thickness of the layer is adapted to favour growth of nanowires 3 along the surface. For example, a film of Fe having a thickness of 0.4 nm can be used. Details regarding the catalyst and growth conditions which favour surface-bound growth can be found in "In situ Observations of Catalyst Dynamics during Surface-Bound Carbon Nanotube Nucleation" by S Hofmann et al., Nano Letters, vol. 7, pp. 602 - 608 (2007). It will be appreciated that the catalytic particle may form the tip of the wire.

Referring to Figure 8c, carbon nanotubes 3 are grown (step S7). The carbon nanotubes 3 are grown using a chemical vapour deposition (CVD) process in a tube furnace (not shown) 900 °C for 5 minutes using methane (CH₄) and hydrogen (H₂) having flow rates of 500 sccm and 100 sccm respectively. Using a Fe catalyst, the carbon nanotubes 3 have lengths of up to 5 µm. It will be appreciated that other growth conditions may be used in which nanowire are bound to the surface of the (etched) substrate and, thus, grow along the surface.

As shown in Figure 8c, carbon nanotubes 3 grow in different directions across the floor 5 of the pit 6. However, the wall 7 prevents presents a barrier to propagating nanotubes 3, for example deflecting nanotubes along the wall 7, upwards, downwards and even back into the pit 7. Furthermore, the overhanging profile of the wall 7 helps prevent the nanotubes from scaling over the wall 7. However, carbon nanotubes 3 are allowed to grow through the opening 9 in the wall 7 and to continue through opening 10 in the second wall 11.

Growth conditions can be adapted to alter the density of nanotubes 3 and, thus, control the number of the nanotubes passing through the opening 9 of given size. For example, the density may be sufficiently small, but not so small, that the probability of just one carbon nanotubes 3 passing through the opening 9 is higher than the probability of two or more. Alternatively, the density may be sufficiently high, but not so high that many carbon nanotubes 3 pass through the opening 9 and that the number of nanotubes 3 is limited by the size of the opening 9.

A ramp 15 or another structure is optionally provided to enable a contact or conducting track to exit the pit 6 (step S8). A layer of polymer resist (not shown) is applied and patterned to provide a mask layer (not shown) and a layer of silicon dioxide is deposited, for example by sputtering. Portions of the layer of silicon dioxide overlying resist are lifted-off in acetone. The corresponding structure, including the ramp 5, is shown in Figure 8d. The ramp 15 may be defined before the catalyst pad 4 is fabricated and may be defined before the nanowires 3 are grown.

Source and drain contacts 13, 14 are provided (step S9). A layer of polymer resist (not shown) is applied and patterned to provide a mask layer (not shown). A layer (or successive layers) of metal is (are) deposited, for example by physical vapour deposition techniques, such as thermal evaporation, and portions of the layer(s) overlying resist are lifted-off in acetone. The metals may be titanium (Ti), palladium (Pd), aluminium (Al) or gold (Au). Other physical vapour deposition techniques may be used, such as sputtering. Chemical vapour deposition techniques may be used.

Contacts (not shown) are formed to the split gate 12 (step S10). For example, aluminium (AI) contacts may be deposited and sintered to provide ohmic contacts. The contacts may be defined before the catalyst pad 4 is fabricated and may be defined before the nanowires 3 are grown.

Using the method hereinbefore described, a nanowire device can be fabricated in which the path taken by nanowires along the substrate can be controlled or constrained. Furthermore, the method is better suited than conventional processes to fabricating nanowire devices in high volumes.

Similar methods can be used to fabricate other types of device.

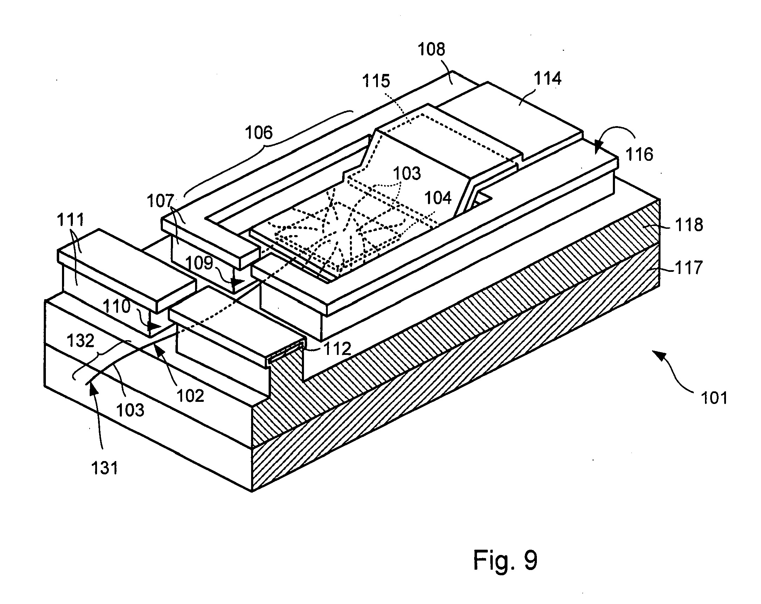

Referring to Figure 9, another nanowire device 101 in accordance with the present invention is shown. The device 1' is similar to the device 1 hereinbefore described.

The nanowire device 101 is an electron source having a filament 102 provided by a nanowire 103. The nanowire 103 is one of a plurality of nanowires 103 stemming from a catalyst pad 104 disposed on a base 105 (or "floor") of a pit (hereinafter referred to as an "enclosure") defined by a wall portion 107 of a mesa 108 which provides a barrier preventing nanowires 103 from leaving the enclosure 106 except through an opening 9 (herein also referred to as an "exit"). The nanowire 103 extends through another opening 110 in another wall 111 which provides first and second sides of a split gate 112. Thus, the filament 2 and gate 112 are self-aligned.

The nanowire 103 is contacted at one end by source contacts 113. Optionally, a dielectric pad 115 is provided which overlaps an edge of the mesa 108 inside the enclosure 106 to provide a bridge which allows the source contact 113 to run from the base 105 of the enclosure 106 onto an upper surface 116 of the mesa 108.

The nanowires 103 are single-walled carbon nanotubes (SWNT). However, the nanowires may be multiple-walled carbon nanotubes (MWNT) or nanorods, for example formed of silicon, another semiconductor material, metal, such as titanium (Ti) or metal alloy. In some embodiments, the nanowires may be formed of lanthanum hexaboride (LaB₆), for example as described in "Field Emission of Electrons from Single LaB6 Nanowires", H. Zhang et al., Advanced Materials, volume 18, pp. 87 - 91 (2006).

The nanowire device 101 is fabricated in the same way to the nanowire device 1 (Figure 1) described earlier, i.e. from a substrate 17' (Figure 7a) which includes a silicon base layer 18 (Figure 7a), a silicon dioxide layer 19' (Figure 7a), a silicon layer 20' (Figure 7a) and a capping silicon dioxide layer 21' (Figure 7a).

The nanowire device 101 differs from the nanowire device 1 in that there is no drain contact and that one end 131 of the nanowire 103 is free and projects into space 132.

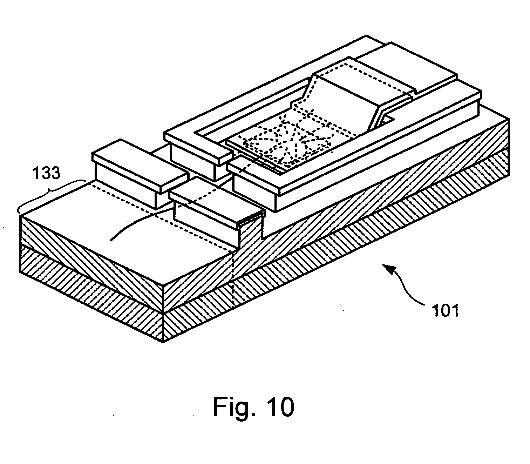

Referring to Figure 10, the space 132 (Figure 9) is formed by etching a portion 133 of substrate 117, 118, for example using KOH or HF aqueous solution.

The substrate 117, 118 may be etched before or after growth of the nanowires 103. For example, the substrate 117, 118 may be etched through as a first stage to form a web (not shown) for supporting a plurality (e.g. an array) of electron sources. Once the electron sources have been fabricated, the web (now shown) may be cleaved at weak spots to provide individual electron sources.

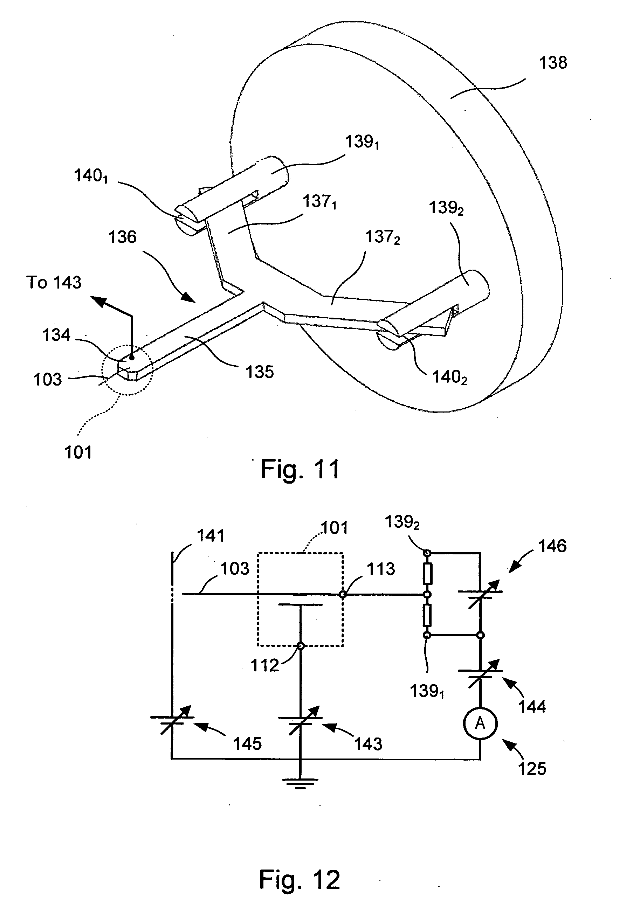

Referring to Figure 11, the electron source 101 is arranged at a distal end 134 of a stem 135 of a 'Y'-shaped cathode 136 having first and second arms 137₁, 137₂. The cathode 136 is installed in a cathode holder 138 having first and second pins 139₁, 139₂ having respective slots 140₁, 140₂ for receiving and holding the arms 137₁, 137₂.

Referring to Figure 12, the electron source 101 is provided with an extractor electrode 141, for example in the form of a perforated sheet. The cathode holder 138 or the extractor electrode 141 is mounted on a moveable stage (not shown) and the electron source 101 and the extractor electrode 134 are brought together.

As shown in Figure 12, first and second voltage sources 142, 143 are used to apply biases to the emitter 102 and the gate 112 respectively. A current meter 144 is used to measure source-drain current, *I_{SD}*. A third voltage source 145 is used to apply an extraction voltage to the extractor electrode 141. A fourth voltage source 146 is arranged between the pins 139₁, 139₂ to supply a heater current.

As shown schematically in Figure 11, the voltage source 143 is connected to the gate 112 via a bondpad (not shown) on the substrate 117, 118 (Figure 9) and a bondwire (not shown).

It will be appreciated that many modifications may be made to the embodiments hereinbefore described.

Other type of nanowires can used, such as single element nanowires, group III-V nanowires, group II-VI, metal oxide nanowires, metal chalogenide nanowires, ternary chalogenide nanowires and conducing polymer nanowires.

The opening or exit 9, 10 can have different shapes. For example, the exit may be tapered or be curved (e.g. through a 90° turn).

Other gating arrangements may be used. For example, the silicon base layer 18 may be used as a back gate. A top gate, separated from the nanowires by a dielectric layer, may be used. A self-aligned side gate may be used, such as an arrangement described in "Fabrication of self-aligned side gates to carbon nanotubes", L. A. W. Robinson et al., Nanotechnology, vol. 14, p. 290 (2003).

Other substrates can be used, such as silicon-on-sapphire (SOS).

Larger wires, for example wires having a diameter of the order of 1 or 10 µm, can also be used. For example, micron-sized particles, e.g. colloidal particles, of catalyst may be used to nucleate growth. Thus, the device need not be a nanowire device, but can be, for example, a microwire device.

## Claims

1. A method of guiding nanowire growth, the method including:
providing a barrier (11) on a surface of a substrate (17) such that the barrier is arranged to impede nanowires growing across the surface;
providing a passage (10) through the barrier, the passage being parallel to the substrate surface;
providing a region of catalyst (4) for nucleating growth of nanowires (3) on the surface of the substrate and adjacent to the barrier;
**characterized in that** the barrier has an overhanging profile.

2. A method according to claim 1, comprising:
arranging the region (4) to be wider than an opening to the passage.

3. A method according to claim 1 or 2, comprising:
arranging the barrier (11) and catalyst region (4) on an upper surface of a substrate (17) such that barrier is arranged to impede nanowires (3) growing along the upper surface.

4. A method according to any preceding claim, wherein providing the region of catalyst (4) comprises providing a region of cobalt, iron, nickel, gold, platinum and/or copper.

5. A method according to any preceding claim, further comprising:
growing nanowires (3),
whereby at least one nanowire (3₁) stems from the catalyst region (4) into the passage.

6. A method according to claim 5, wherein growing nanowires (3) comprises growing nanowires by chemical vapour deposition.

7. A method according to claim 6 or 7, wherein growing nanowires (3) comprises growing carbon nanotubes.

8. A method according to any preceding claim, further comprising:
providing another barrier (7); and
providing a passage (9) through the other barrier

9. A method according to claim 10, comprising:
arranging the other barrier (7) between the catalyst region (4) and the barrier (11); and
aligning the passage (9) through the other barrier with the passage (10) through the barrier.

10. A method according to any preceding claim, further comprising:
providing a conductive region (12) in the barrier or the other barrier on at least one side of the passage for applying an electric field within the passage (10).

11. A method according to any preceding claim, comprising:
arranging the passage (9, 10) to have a width less than or equal to 1 µm.

12. A method according to any preceding claim, comprising:
arranging for an edge of the catalyst region (4) to be less than or equal to 5 µm from an opening of the passage.

13. A device comprising:
a substrate (17);
a barrier (11) on a surface of the substrate (17) wherein the barrier is arranged to impede nanowires growing across the surface;
a passage (10) through the barrier, the passage being parallel to the substrate surface; and
a region of catalyst (4) for nucleating growth of nanowires on the surface of the substrate and adjacent to the barrier,
**characterised in that** the barrier has an overhanging profile.

14. A device according to claim 13, wherein the region (4) is wider than an opening to the passage.

15. A device according to claim 13 or 14, wherein the barrier (11) and catalyst region (4) are disposed on an upper surface of a substrate such that the barrier is arranged to impede nanowires (3) growing along the upper surface.

16. A device according to any one of claims 13 to 15, wherein the region of catalyst (4) comprises cobalt, iron, nickel, gold, platinum and/or copper.

17. A device according to any one of claims 13 to 15, further comprising nanowires (3), wherein at least one nanowire (3₁) stems from the catalyst region (4) into the passage.

18. A device according to claim17, wherein only one nanowire (3₁) stems from the catalyst region (4) into the passage.

19. A device according to claim 17 or 18, wherein the nanowires (3) comprise carbon nanotubes.

20. A device according to claim17 or 18, wherein the nanowires (3) comprise semiconductor nanorods.

21. A device according to any one of claims 13 to 20, further comprising:
another barrier (7); and
a passage (9) through the other barrier.

22. A device according to claim 21, wherein the other barrier (7) between the catalyst region (4) and the barrier (11) and the passage (9) through the other barrier is aligned with the passage (10) through the barrier.

23. A device according to any one of claims 13 to 22, wherein the barrier (11) or other barrier (7) includes a conductive region (12) on at least one side of the passage (9, 10) for applying an electric field within the passage.

24. A device according to any one of claims 13 to 22, wherein the passage (9, 10) has a width less than or equal to 1 µm.

25. A device according to any one of claims 13 to 24, wherein an edge of the catalyst region (4) is less than or equal to 5 µm from an opening of the passage (10).

## Patentansprüche

1. Verfahren zum Ausrichten des Wachstums von Nanodrähten, wobei das Verfahren umfasst:
Bereitstellen einer Barriere (11) auf einer Oberfläche eines Substrats (17) derart, dass die Barriere dazu ausgelegt ist, Nanodrähte zu behindern, die über die Oberfläche hinweg wachsen;
Bereitstellen eines Durchgangs (10) durch die Barriere, wobei der Durchgang parallel zur Substratoberfläche ist;
Bereitstellen eines Katalysatorbereichs (4), um als Nukleus für ein Wachsen von Nanodrähten (3) auf der Oberfläche des Substrats und angrenzend an die Barriere zu dienen;
**dadurch gekennzeichnet, dass** die Barriere ein überhängendes Profil aufweist.

2. Verfahren nach Anspruch 1, umfassend:
Anordnen des Bereichs (4) derart, dass er breiter ist als eine Öffnung des Durchgangs.

3. Verfahren nach Anspruch 1 oder 2, umfassend:
Anordnen der Barriere (11) und des Katalysatorbereichs (4) auf einer oberen Oberfläche eines Substrats (17) derart, dass die Barriere dazu ausgelegt ist, Nanodrähte (3) zu behindern, die entlang der oberen Oberfläche wachsen.

4. Verfahren nach einem der vorhergehenden Ansprüche, wobei das Bereitstellen des Katalysatorbereichs (4) ein Bereitstellen eines Bereichs aus Cobalt, Eisen, Nickel, Gold, Platin und/ oder Kupfer umfasst.

5. Verfahren nach einem der vorhergehenden Ansprüche, ferner umfassend:
Wachsen von Nanodrähten (3), wobei wenigstens ein Nanodraht (3₁) vom Katalysatorbereich (4) in den Durchgang hinein verläuft.

6. Verfahren nach Anspruch 5, wobei das Wachsen der Nanodrähte (3) ein Wachsen der Nanodrähte durch chemische Gasphasenabscheidung umfasst.

7. Verfahren nach Anspruch 6 oder 7, wobei das Wachsen der Nanodrähte (3) ein Wachsen von Kohlenstoff-Nanoröhrchen umfasst.

8. Verfahren nach einem der vorhergehenden Ansprüche, ferner umfassend:
Bereitstellen einer weiteren Barriere (7); und
Bereitstellen eines Durchgangs (9) durch die weitere Barriere.

9. Verfahren nach Anspruch 8, umfassend:
Anordnung der weiteren Barriere (7) zwischen dem Katalysatorbereich (4) und der Barriere (11); und
Ausrichten des Durchgangs (9) durch die weitere Barriere mit dem Durchgang (10) durch die Barriere.

10. Verfahren nach einem der vorhergehenden Ansprüche, ferner umfassend:
Bereitstellen eines leitfähigen Bereichs (12) in der Barriere oder der weiteren Barriere auf wenigstens einer Seite des Durchgangs zum Anlegen eines elektrischen Felds innerhalb des Durchgangs (10).

11. Verfahren nach einem der vorhergehenden Ansprüche, umfassend:
Anordnen des Durchgangs (9, 10) derart, dass er eine Breite kleiner oder gleich 1 µm hat.

12. Verfahren nach einem der vorhergehenden Ansprüche, umfassend:
Anordnen einer Ecke des Katalysatorbereichs (4) derart, dass sie einen Abstand kleiner oder gleich 5 µm von einer Öffnung des Durchgangs hat.

13. Vorrichtung, umfassend:
ein Substrat (17);
eine Barriere (11) auf einer Oberfläche des Substrats (17), wobei die Barriere dazu ausgelegt ist, Nanodrähte zu behindern, die über die Oberfläche hinweg wachsen;
einen Durchgang (10) durch die Barriere, wobei der Durchgang parallel zu der Substratoberfläche ist; und
einen Katalysatorbereich (4), um als Nukleus für das Wachsen von Nanodrähten auf der Oberfläche des Substrats und angrenzend an die Barriere zu dienen,
**dadurch gekennzeichnet, dass** die Barriere ein überhängendes Profil aufweist.

14. Vorrichtung nach Anspruch 13, wobei der Bereich (4) breiter als eine Öffnung des Durchgangs ist.

15. Vorrichtung nach Anspruch 13 oder 14, wobei die Barriere (11) und der Katalysatorbereich (4) auf einer oberen Oberfläche eines Substrats derart angeordnet sind, dass die Barriere dazu ausgelegt ist, Nanodrähte (3) zu behindern, die entlang der oberen Oberfläche wachsen.

16. Vorrichtung nach einem der Ansprüche 13 bis 15, wobei der Katalysatorbereich (4) Cobalt, Eisen, Nickel, Gold, Platin und/ oder Kupfer umfasst.

17. Vorrichtung nach einem der Ansprüche 13 bis 15, ferner umfassend Nanodrähte (3), wobei wenigstens ein Nanodraht (3₁) von dem Katalysatorbereich (4) in den Durchgang hinein verläuft.

18. Vorrichtung nach Vorrichtung 17, wobei nur ein Nanodraht (3₁) von dem Katalysatorbereich (4) in den Durchgang hinein verläuft.

19. Vorrichtung nach Anspruch 17 oder 18, wobei die Nanodrähte (3) Kohlenstoff-Nanoröhrchen umfassen.

20. Vorrichtung nach Anspruch 17 oder 18, wobei die Nanodrähte (3) Halbleiter-Nanostäbe umfassen.

21. Vorrichtung nach einem der Ansprüche 13 bis 20, ferner umfassend:
eine weitere Barriere 7; und
einen Durchgang (9) durch die weitere Barriere.

22. Vorrichtung nach Anspruch 21, wobei die weitere Barriere (7) zwischen dem Katalysatorbereich (4) und der Barriere (11) und der Durchgang (9) durch die weitere Barriere mit dem Durchgang (10) durch die Barriere ausgerichtet ist.

23. Vorrichtung nach einem der Ansprüche 13 bis 22, wobei die Barriere (11) oder die weitere Barriere (7) einen leitfähigen Bereich (12) auf wenigstens einer Seite des Durchgangs (9, 10) zum Anlegen eines elektrischen Felds innerhalb des Durchgangs umfasst.

24. Vorrichtung nach einem der Ansprüche 13 bis 22, wobei der Durchgang (9, 10) eine Breite kleiner oder gleich 1 µm hat.

25. Vorrichtung nach einem der Ansprüche 13 bis 24, wobei eine Kante des Katalysatorbereichs (4) einen Abstand kleiner oder gleich 5 µm von einer Öffnung des Durchgangs (10) aufweist.

## Revendications

1. Procédé destiné à guider la croissance de nanofils, le procédé comportant le fait :
de prévoir une barrière (11) sur une surface d'un substrat (17) de sorte que la barrière soit agencée pour entraver la croissance de nanofils à travers la surface ;
de prévoir un passage (10) traversant la barrière, le passage étant parallèle à la surface du substrat ;
de prévoir une région de catalyseur (4) pour la nucléation de la croissance de nanofils (3) sur la surface du substrat et adjacente à la barrière ;
**caractérisé en ce que** la barrière a un profil en porte-à-faux.

2. Procédé selon la revendication 1, comprenant le fait :
d'agencer la région (4) de manière à ce qu'elle soit plus grande qu'une ouverture sur le passage.

3. Procédé selon la revendication 1 ou 2, comprenant le fait :
d'agencer la barrière (11) et la région de catalyseur (4) sur une surface supérieure d'un substrat (17) de sorte que la barrière soit agencée pour entraver la croissance de nanofils (3) le long de la surface supérieure.

4. Procédé selon l'une quelconque des revendications précédentes, dans lequel le fait de prévoir la région de catalyseur (4) comprend le fait de prévoir une région de cobalt, de fer, de nickel, d'or, de platine et/ou de cuivre.

5. Procédé selon l'une quelconque des revendications précédentes, comprenant en outre le fait :
de faire croître des nanofils (3),
moyen par lequel au moins un nanofil (3₁) provient de la région de catalyseur (4) dans le passage.

6. Procédé selon la revendication 5, dans lequel la croissance de nanofils (3) comprend la croissance de nanofils par dépôt chimique en phase vapeur.

7. Procédé selon la revendication 6 ou 7, dans lequel la croissance de nanofils (3) comprend la croissance de nanotubes de carbone.

8. Procédé selon l'une quelconque des revendications précédentes, comprenant en outre le fait :
de prévoir une autre barrière (7) ; et
de prévoir un passage (9) traversant l'autre barrière.

9. Procédé selon la revendication 8, comprenant le fait :
d'agencer l'autre barrière (7) entre la région de catalyseur (4) et la barrière (11) ; et
d'aligner le passage (9) traversant l'autre barrière avec le passage (10) traversant la barrière.

10. Procédé selon l'une quelconque des revendications précédentes, comprenant en outre le fait :
de prévoir une région conductrice (12) dans la barrière ou l'autre barrière sur au moins un côté du passage pour appliquer un champ électrique dans le passage (10).

11. Procédé selon l'une quelconque des revendications précédentes, comprenant le fait :
d'agencer le passage (9, 10) pour avoir une largeur inférieure ou égale à 1 µm.

12. Procédé selon l'une quelconque des revendications précédentes, comprenant le fait :
d'agencer un bord de la région de catalyseur (4) de manière à ce qu'il soit inférieur ou égal à 5 µm à partir d'une ouverture du passage.

13. Dispositif comprenant :
un substrat (17) ;
une barrière (11) sur une surface du substrat (17) où la barrière est agencée pour entraver la croissance de nanofils à travers la surface ;
un passage (10) à travers la barrière, le passage étant parallèle à la surface du substrat ; et
une région de catalyseur (4) pour la nucléation de la croissance de nanofils sur la surface du substrat et adjacente à la barrière,
**caractérisé en ce que** la barrière a un profil en porte-à-faux.

14. Dispositif selon la revendication 13, dans lequel la région (4) est plus large qu'une ouverture au passage.

15. Dispositif selon la revendication 13 ou 14, dans lequel la barrière (11) et la région de catalyseur (4) sont disposées sur une surface supérieure d'un substrat de sorte que la barrière soit agencée pour entraver la croissance de nanofils (3) le long de la surface supérieure.

16. Dispositif selon l'une quelconque des revendications 13 à 15, dans lequel la région de catalyseur (4) comprend du cobalt, du fer, du nickel, de l'or, du platine et/ou du cuivre.

17. Dispositif selon l'une quelconque des revendications 13 à 15, comprenant en outre des nanofils (3), dans lequel au moins un nanofil (3₁) provient de la région de catalyseur (4) dans le passage.

18. Dispositif selon la revendication 17, dans lequel seul un nanofil (3₁) provient de la région de catalyseur (4) dans le passage.

19. Dispositif selon la revendication 17 ou 18, dans lequel les nanofils (3) comprennent des nanotubes de carbone.

20. Dispositif selon la revendication 17 ou 18, dans lequel les nanofils (3) comprennent des nanotiges semiconductrices.

21. Dispositif selon l'une quelconque des revendications 13 à 20, comprenant en outre :
une autre barrière (7) ; et
un passage (9) traversant l'autre barrière.

22. Dispositif selon la revendication 21, dans lequel l'autre barrière (7) entre la région de catalyseur (4) et la barrière (11) et le passage (9) traversant l'autre barrière s'alignent avec le passage (10) traversant la barrière.

23. Dispositif selon l'une quelconque des revendications 13 à 22, dans lequel la barrière (11) ou l'autre barrière (7) comporte une région conductrice (12) sur au moins un côté du passage (9, 10) pour appliquer un champ électrique dans le passage.

24. Dispositif selon l'une quelconque des revendications 13 à 22, dans lequel le passage (9, 10) a une largeur inférieure ou égale à 1 µm.

25. Dispositif selon l'une quelconque des revendications 13 à 24, dans lequel un bord de la région de catalyseur (4) est inférieur ou égal à 5 µm à partir d'une ouverture du passage (10).
